Europäisches Patentamt

European Patent Office

Office européen des brevets

(19)

(11) Veröffentlichungsnummer : **0 271 543
B1**

(12)

# EUROPÄISCHE PATENTSCHRIFT

(45) Veröffentlichungstag der Patentschrift :
03.01.90

(21) Anmeldenummer : 87904010.3

(22) Anmeldetag : 19.06.87

(86) Internationale Anmeldenummer :
PCT/AT 87/00037

(87) Internationale Veröffentlichungsnummer :
WO/8707978 (30.12.87 Gazette 87/29)

(51) Int. Cl.⁵ : **H 01 J 49/14**

(54) VERFAHREN ZUR ÜBERPRÜFUNG DER ENERGIE EINES IONENSTRAHLES.

(30) Priorität : 20.06.86 AT 1680/86

(43) Veröffentlichungstag der Anmeldung :
22.06.88 Patentblatt 88/25

(45) Bekanntmachung des Hinweises auf die Patenterteilung : 03.01.90 Patentblatt 90/01

(84) Benannte Vertragsstaaten :
CH DE FR GB LI

(56) Entgegenhaltungen :

Keine

(73) Patentinhaber : LINDINGER, Werner
Gufeltalweg 11
A-6020 Innsbruck (AT)

(72) Erfinder : LINDINGER, Werner
Gufeltalweg 11
A-6020 Innsbruck (AT)

(74) Vertreter : Hofinger, Engelbert et al
Torggler-Hofinger Wilhelm-Greil-Strasse 16
A-6020 Innsbruck (AT)

## Beschreibung

Die Erfindung betrifft ein Verfahren zur Überprüfung bzw. Einstellung des genauen Wertes der generell unter 2 eV liegenden Energie der von einer Ionenquelle ausgesandten und in Form eines Strahles in eine Reaktionskammer gelangten Krypton-Ionen (Kr⁺-Ionen), welche in der Reaktionskammer Ionen-Molekülreaktionen verursachen, deren Reaktionsprodukte massenspektrographisch nachweisbar sind.

Bei der Untersuchung von Ionen-Molekülreaktionen werden Ionen definierter Energie auf neutrale Moleküle gerichtet. Die Wechselwirkung zwischen Ionen und Molekül kann dabei im einfachen Ladungsaustausch bestehen. Es kann jedoch auch zu einer chemischen Veränderung des getroffenen Moleküls, z. B. durch Dissoziation, kommen. Masse und Ladung der Reaktionsprodukte lassen sich in einem Massenspektrometer analysieren. Dies geschieht heute primär zu dem Zweck, die Wirkungsquerschnitte der verschiedenen Ionen-Molekülreaktionen bei verschiedenen Energien festzustellen.

Die Anwendung des geschilderten Verfahrens auf die Analyse der Zusammensetzung des mit Ionen beschossenen Gases, insbesondere auf die Messung von Luftverunreinigungen, ist nur unter ganz bestimmten Bedingungen möglich. Um mit einem einzigen Ionenstrahl die Abgase von Verbrennungsprozessen simultan auf CO, NO und $NO_2$ untersuchen zu können, ist die Verwendung einer Ionenquelle wesentlich, welche Ionen mit einer Energie unter 2 eV aussendet, welche einerseits die relevanten Schadstoffe ionisieren, andererseits aber die Komponenten des Gasgemisches nicht dissoziieren. Dabei ist darauf zu achten, daß die Ionen-Molekülreaktion unter Einzelstoßbedingungen im Vakuum erfolgt. Die erzeugten Produkt-Ionen sollen also nicht ihrerseits wieder auf schwer kontrollierbare Weise Folgeprodukte erzeugen. Als Ionen, die sich zur Messung von Luftverunreinigungen eignen, haben sich Krypton-Ionen herausgestellt, weil diese bei den verwendeten niederen Energien mit dem in Luft vorhandenen Stickstoff nicht und mit Sauerstoff nicht rasch reagieren.

Auch in jenen Fällen, in denen Molekülreaktionen der beschriebenen Art lediglich zur Messung von Luftverunreinigungen herangezogen werden und Einzelheiten der Reaktion als solcher nicht weiter interessieren, ist es doch notwendig, die Energie der auf das zu untersuchende Gas auftreffenden Krypton-Ionen auf einem vorbestimmten Wert zu halten, da die Erzeugungsrate der Produkt-Ionen unterschiedlich energieabhängig ist. Eine direkte Messung der Spannung zwischen Emissionsfaden der Ionenquelle und Reaktionskammer ist daher nur für eine Großeinstellung der Ionenenergie zielführend, da bereits kleine Veränderungen der Oberflächenbelegungen (wie sie insbesondere beim Vorhandensein verschiedener Gasverunreinigungen gegeben sind) in Blendensystemen in der Ionenquelle bzw. auch in der Reaktionskammer zu Änderungen der Kontaktpotentiale in der Größenordnung von mehreren 0.1 V führen, womit die Energie der Ionen um ebensoviele 0.1 eV verändert wird.

Das bei der wissenschaftlichen Untersuchung von Molekülreaktionen häufig angewendete Verfahren, die Energie der zur Untersuchung dienenden Ionen zu vereinheitlichen, indem diese durch ein Puffergas geleitet werden, scheidet im vorliegenden Fall aus, wo ein Ionenstrahl in einer weitgehend evakuierten Reaktionskammer Reaktionen hervorrufen soll. Die in solchen Fällen bereits vorgeschlagene Anwendung elektrischer und magnetischer Felder zur Ausblendung eines Teiles des Ionenstrahls in Abhängigkeit von seiner Energie ist für kommerzielle Anwendungen auf Ionen-Molekülreaktionen zu teuer.

Es ist bereits bekannt (vergl. International Journal of Mass-Spectrometry and Ion Physics 52 (1983), Seiten 1-24 und 14 (1974), Seiten 171-181), gerade aus der Energieabhängigkeit von Ionen-Molekülreaktionen Rückschlüsse auf die Energie des Ionenstrahles zu ziehen. Bei der bekannten Ionen-Molekül-Reaktion wird das Verhältnis der Produktionsraten zweier Reaktionsprodukte ermittelt, welches nicht vom Absolutwert des Produkt-Ionenstroms abhängen. Dieser Absolutwert hängt nämlich von verschiedenen Größen ab, etwa der Geometrie der Anordnung, der Intensität des Ionenstroms, der Dichte des untersuchten Gases usw. und würde keine einfachen Rückschlüsse auf die Ionenenergie erlauben. Die beiden Reaktionsprodukte ($O_2^+$, $NO^+$), deren Verhältnis ermittelt wird, stammen dabei aus verschiedenen Produktzweigen der Reaktion der eingestrahlten Ionen ($N^+$) mit dem gleichen Reaktionspartner ($O_2$).

Zur Eichung einer Krypton-Ionenquelle ist ein derartiges Verfahren ungeeignet, da Krypton-Ionen zumindest mit den in der Praxis günstigen Gasen keine Reaktionen mit Produktverzweigungen ausführen, deren energieabhängiges Verzweigungsverhältnis dann Rückschlüsse auf die Ionenenergie erlauben würde.

Aufgabe der Erfindung ist es, ein einfaches, kommerziell anwendbares Verfahren der eingangs genannten Gattung zur Überprüfung bzw. Einstellung der genauen Energie von Krypton-Ionen anzugeben.

Erfindungsgemäß ist vorgesehen, daß ein Sauerstoff und Kohlendioxid enthaltendes Eichgas in die Reaktionskammer gefüllt wird und daß die Spannung, welche die Ionen zwischen Ionenquelle und Reaktionskammer beschleunigt, so lange verändert wird, bis das energieabhängige Verhältnis der Produktionsraten der beiden aus der Reaktion der Kr⁺-Ionen mit $O_2$ und $CO_2$ stammenden Reaktionsprodukte einen vorgegebenen Wert annimmt.

Der Erfindung liegt die Idee zugrunde, als Eichgas ein Gasgemisch zu verwenden und das energieabhängige Verhältnis der Produkionsrate eines Reaktionsproduktes der Krypton-Ionen mit der einen Gassorte und der Produktionsrate eines anderen Reaktionsproduktes der Krypton-Ionen mit der

anderen Gassorte zu benutzen, um auf die Energie der Krypton-Ionen zu schließen. Es hat sich gezeigt, daß sich diese Idee mit einem einfachen Sauerstoff und Kohlendioxid enthaltenden Gas verwirklichen läßt. Als Eichgas eignet sich saubere Luft, wobei hier das Vorurteil überwunden wird, daß der in der Luft dominierende Stickstoff den Spinzustand der Krypton-Ionen und damit die bekannt spinabhängige Reaktionsrate mit Sauerstoff beeinträchtigen könnte. Es wurde nämlich ermittelt, daß die Quenchrate für die Überführung von einem Spinzustand der Krypton-Ionen in den anderen, energetisch niedrigeren Spinzustand durch Stöße mit $N_2$ klein genug ist, so daß das bekannte statische Verhältnis der im einen und anderen Spinzustand aus der Ionenquelle kommenden Krypton-Ionen auch im Reaktionsraum erhalten bleibt.

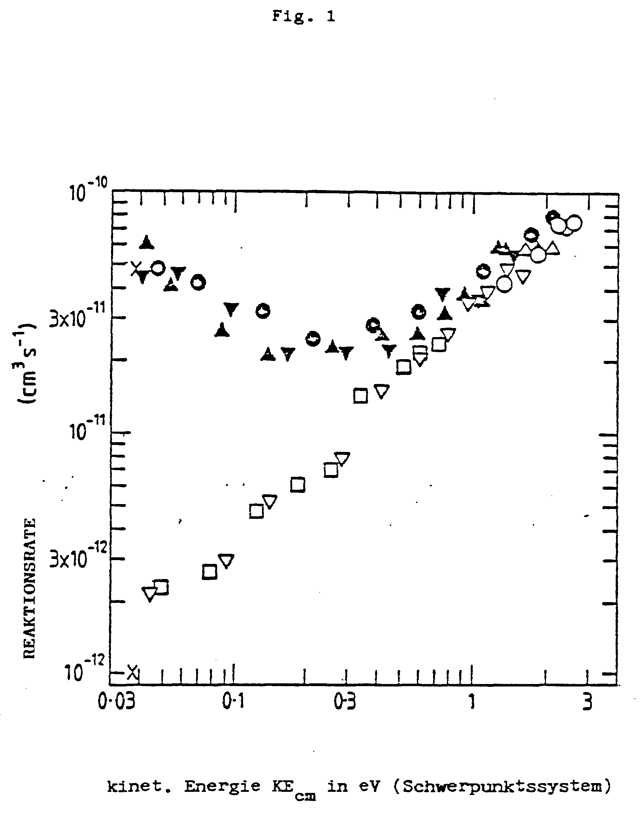

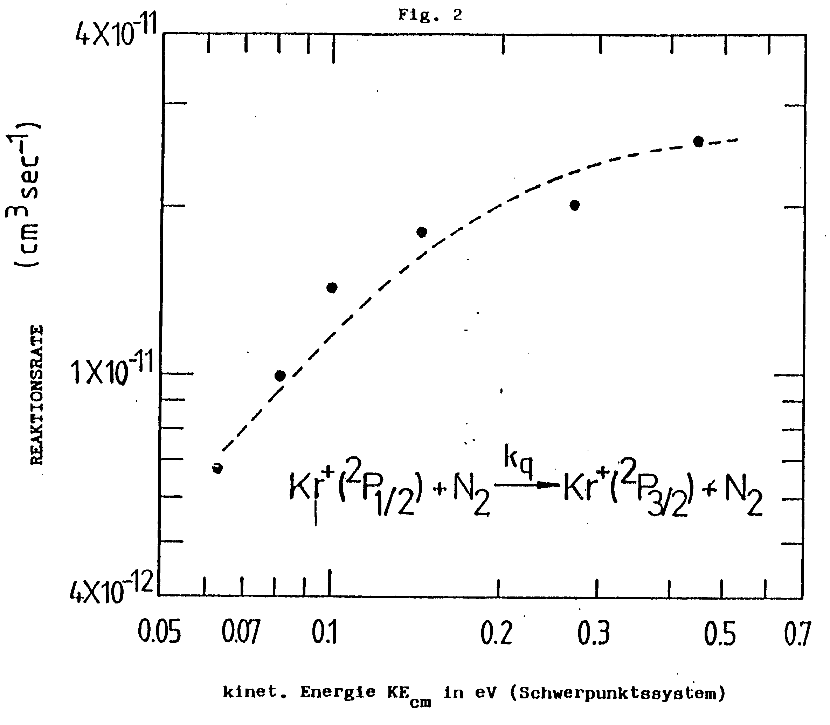

Die Beschreibung erfolgt anhand von Diagrammen, wobei Fig. 1 die Reaktionsrate für $Kr^+$ und $O_2^+$ nach T.T.C. Jones, Thesis Univ. Aberystwyth 1982, und Fig. 2 die Reaktionsrate für den Übergang der Krypton-Ionen zwischen verschiedenen Spinzuständen infolge von Stößen and $N_2$ darstellt.

Die detaillierte Beschreibung der zur Durchführung des Verfahrens verwendeten Einrichtung kann unterbleiben, da diese an sich bereits bekannt sind. Beispielsweise findet sich eine schematische Darstellung einer verwendbaren Anordnung zusammen mit Literaturhinweisen, welche einzelne Details erläutern, in einer Arbeit von H. Villinger, J. H. Futrell, A. Saxer, R. Richter und W. Lindinger in J. Chem. Phys. 80 (6), 15. März 1984. Die verwendeten niederenergetischen Krypton-Ionen können dabei mit einer Ionenquelle erzeugt werden, die auf dem Prinzip des Elektronenstoßes basiert. Derartige Ionenquellen werden beispielsweise von der Firma Balzers unter der Bestellnummer BG 528 370 T vertrieben. Ein an die Ionenquelle anschließendes Oktopol-System erzeugt ein hochfrequentes Feld, welches den Ionenstrahl am Auseinanderlaufen hindert. Anschließend gelangen die Ionen in die Reaktionskammer, in welche das zu untersuchende Gas eingeführt wird. Zur Untersuchung des aus der Reaktionskammer kommenden Strahls dient ein Quadrupol-Massenspektrometer, welches nur Ionen bestimmter Masse zu einer bekannten Auswerteelektronik durchläßt. Die Dichte des zu untersuchenden Gases im Reaktionsbereich liegt typischerweise in der Größenordnung von 1,33 Pa ($10^{-2}$ Torr), wogegen im Bereich der Ionenquelle und des Massenspektrometers die freie Weglänge des Gases größer sein soll als die Geräteabmessungen, also ein Vakuum von beispielsweise $133 \times 10^{-5}$ Pa ($10^{-5}$ Torr) aufrechterhalten wird.

Um die Energie der Krypton-Ionen auf einem niedrigen reproduzierbar einstellbaren Wert zwischen 0.2 und 0.5 eV zu halten, wird von Zeit zu Zeit normale, nicht verunreinigte atmosphärische Luft in die Reaktionskammer eingefüllt, die Produktionsraten für $O_2^+$ und $CO_2^+$ werden gemessen. Die als Eichgas verwendete Luft enthält

78.084 Volums-% $N_2$
20.946 Volums-% $O_2$
0.934 Volums-% Argon
0.033 Volums-% $CO_2$

sowie $H_2O$ und in diesem Zusammenhang vernachlässigbare Spurmengen anderer Gase.

Während $Kr^+$ bei niederenergetischen Stößen ($KE_{cm} < 1.5$ eV) nicht mit $N_2$ bzw. Ar reagiert, führt es sowohl mit $O_2$, wie auch mit $CO_2$ Ladungstauschprozesse durch, wobei im Falle von $O_2$ die Reaktionsraten sowohl von der kinetischen Energie der Stoßpartner, wie auch vom Spinzustand der $Kr^+$ Ionen abhängen. Diese Abhängigkeit ist in Fig. 1 dargestellt, wo sich die geschwärzten Meßwerte auf den Spinzustand 3/2, die weiß dargestellten Daten auf den Spinzustand 1/2 beziehen. Für $CO_2$ gilt $k = 6.3 \times 10^{-10}$ cm³ sec⁻¹, unabhängig von $KE_{cm}$ und dem Spinzustand der $Kr^+$-Ionen. In dem aus der Ionenquelle kommenden Ionenstrahl sind $Kr^+(^2P_{1/2})$ und $Kr^+$ $(^2P_{3/2})$ im statistischen Verhältnis $1:2$ präsent und dieses Verhältnis ändert sich auch nicht im Reaktionsraum, obwohl pro reaktivem Stoß eines $Kr^+$-Ions mehrere Stöße gegen $N_2$ erfolgen. Die Quenchrate, $k_q$, für die Überführung des energetisch höherliegenden $Kr^+(^2P_{1/2})$ in $Kr^+(^2P_{3/2})$,

$$Kr^+(^2P_{1/2}) + N_2 \overset{k_q}{\rightarrow} Kr^+(^2P_{3/2}) + N_2$$

ist klein genug (siehe Fig. 2), sodaß sich das Verhältnis $Kr^+(^2P_{1/2}) : Kr^+(^2P_{3/2})$ trotz der Dominanz von $N_2$ im Eichgas nicht wesentlich ändert. Somit ergibt sich ein Verhältnis der Produkt-Ionenströme $i(O_2^+) : i(CO_2^+)$, wie

$$\frac{i(O_2^+)}{i(CO_2^+)} = \frac{(k_{Kr_{3/2}-O_2} \cdot [Kr^+ (^2P_{3/2})] + k_{Kr_{1/2}-O_2} \cdot [(Kr^+ (^2P_{1/2}))] \cdot [O_2])}{k_{Kr_{1/2,3/2}^+ - CO_2}([Kr^+ (^2P_{3/2})] + [Kr^+ (^2P_{1/2})]) \cdot [CO_2]}$$

Da wie erwähnt die Erzeugungsrate von $i(CO_2^+)$ konstant ist, verändert sich das Verhältnis der Produkt-Ionenströme

$$\frac{i(O_2^+)}{i(CO_2^+)}$$

gemäß Fig. 1, wobei der linke

Ast der weiß dargestellten Meßwerte praktisch zu vernachlässigen ist. Diese Abhängigkeit kann herangezogen werden, um durch Messung des Produkt-Ionen-Verhältnisses bei sauberer trockener Luft als Eichgas die Energie der Krypton-Ionen festzustellen, woraufhin dann die Ziehspannung oder die Blendenspannung der Ionenquelle so lange verändert wird, bis der gewünschte Wert erreicht ist.

**Patentansprüche**

1. Verfahren zur Überprüfung bzw. Einstellung des genauen Wertes der generell unter 2 eV liegenden Energie der von einer Ionenquelle ausgesandten und in Form eines Strahles in eine Reaktionskammer gelangten Krypton-Ionen ($Kr^+$-Ionen), welche in der Reaktionskammer Ionen-Molekül-reaktionen verursachen, deren Reaktionsprodukte massenspektrographisch nachweisbar sind, dadurch gekennzeichnet, daß ein Sauerstoff ($O_2$) und Kohlendioxid ($CO_2$) enthaltendes Eichgas in die Reaktionskammer gefüllt wird und daß die Spannung, welche die Ionen zwischen Ionenquelle und Reaktionskam-mer beschleunigt, so lange verändert wird, bis das energieabhängige Verhältnis der Produktionsraten der beiden aus der Reaktion der $Kr^+$-Ionen mit $O_2$ und $CO_2$ stammenden Reaktionsprodukte ($O_2^+$, $CO_2^+$) einen vorgegebenen Wert annimmt.

2. Verfahren nach Anspruch 1, dadurch gekennzeichnet, daß als Eichgas Luft verwendet wird.

**Claims**

1. A process for checking or adjusting the precise value of the energy, which is generally below 2 eV, of the krypton ions ($Kr^+$-ions) which are emitted by an ion source and which passed in the form of a beam into a reaction chamber and which in the reaction chamber cause ion molecule reactions, the reaction products of which can be detected by mass spectrographic means, characterised in that a calibration gas containing oxygen ($O_2$) and carbon dioxide ($CO_2$) is introduced into the reaction chamber and that the voltage which accelerates the ions between the ion source and the reaction chamber is varied until the energy-dependent ratio of the production rates of the two reaction products ($O_2^+$, $CO_2^+$), which originate from the reaction of the $Kr^+$-ions with $O_2$ and $CO_2$ assumes a predetermined value.

2. A process according to claim 1 characterised in that air is used as the calibration gas.

**Revendications**

1. Procédé pour contrôler et régler la valeur exacte de l'énergie généralement inférieure à 2 eV d'ions de krypton (ions $Kr^+$) qui sont émis par une source d'ions, parviennent dans une chambre de réaction sous la forme d'un faisceau et provoquent dans la chambre de réaction des réactions ions-molécules dont les produits réactionnels peuvent être mis en évidence par spectrographie de masse, caractérisé en ce qu'un gaz-étalon contenant de l'oxygène ($O^2$) et du gaz carbonique ($CO^2$) est introduit dans la chambre de réaction et en ce que la tension qui accélère les ions entre la source d'ions et la chambre de réaction est modifiée jusqu'à ce que le rapport qui est fonction de l'énergie des taux de production des deux produits réactionnels ($O_2^+$, $CO_2^+$) provenant de la réaction des ions $Kr^+$ avec le $O_2$ et le $CO_2$ prenne une valeur prédéterminée.

2. Procédé selon la revendication 1, caractérisé en ce que le gaz-étalon est constitué par de l'air.

4

Fig. 1

kinet. Energie $KE_{cm}$ in eV (Schwerpunktssystem)

1

kinet. Energie KE$_{cm}$ in eV (Schwerpunktssystem)

$$Kr^+(^2P_{1/2}) + N_2 \xrightarrow{k_q} Kr^+(^2P_{3/2}) + N_2$$

REAKTIONSRATE   (cm$^3$ sec$^{-1}$)

Fig. 2